# FASCICULE DE BREVET EUROPEEN

(11) **EP 3 425 801 B1**
(45) Date de publication et mention de la délivrance du brevet: **08.05.2024**
(21) Numéro de dépôt: 18181938.4
(22) Date de dépôt: 05.07.2018
(51) Int. Cl.: H03K 17/082

(54) **CIRCUIT DE PROTECTION CONTRE LES COURTS-CIRCUITS DE DISPOSITIF DE COMMUTATION POUR TRANSISTOR SIC OU GAN MOSFET ET PROCÉDÉ ASSOCIÉ**
SCHUTZSCHALTKREIS ZUM SCHUTZ GEGEN KURZSCHLÜSSE EINER SCHALTVORRICHTUNG FÜR SIC- ODER GAN-MOSFET-TRANSISTOR, UND ENTSPRECHENDES VERFAHREN
SHORT-CIRCUIT PROTECTION CIRCUIT FOR SWITCHING DEVICES FOR SIC OR GAN MOSFET TRANSISTOR AND ASSOCIATED METHOD

(30) Priorité: 06.07.2017 FR 1756382
(43) Date de publication de la demande: 09.01.2019
(73) Titulaire: ALSTOM Holdings, 93400 Saint-Ouen-sur-Seine (FR)
(72) Inventeur: AL KAYAL, Fisal, 1780 WEMMEL (BE)
(74) Mandataire: Lavoix

(56) Documents cités:
- US-A1- 2016 204 097
- JAMSHIDPOUR E ET AL: "Fault tolerant operation of single-ended non-isolated DC-DC converters under open and short-circuit switch faults", 2013 15TH EUROPEAN CONFERENCE ON POWER ELECTRONICS AND APPLICATIONS (EPE), IEEE, 2 septembre 2013 (2013-09-02), pages 1-7, XP032505482, DOI: 10.1109/EPE.2013.6634471

## Description

La présente invention concerne un dispositif de commutation de puissance comprenant au moins un transistor tel que divulgué dans et l'article de Jamshidpour et al. intitulé « Fault tolérant operation of single-ended non-isolated DC-DC converters under open and short-circuit switch faults » du 2 septembre 2013 IEEE 15th European conférence on Power Electronics and Applications, en particulierde type SiC ou GaN MOSFET propre à être parcouru par un courant principal tel que divulgué dans le document US 2016/204097 A1.

De manière connue en soi, un transistor du type SiC ou GaN MOSFET (de l'anglais, respectivement, *«Silicon Carbide*», *«Gallium Nitride»* et *« Métal Oxide Semiconductor Field Effect Transistor »*) appelé également transistor à effet de champ à grille isolée, comprend trois bornes ou contacts électriques, à savoir une grille, un drain et une source.

En particulier, un transistor du type SiC ou GaN MOSFET est utilisable comme interrupteur électrique. En effet, un tel transistor définit un état passant dans lequel le drain est connecté électriquement à la source et un état bloqué dans lequel le drain et la source sont isolés électriquement l'un de l'autre.

La commutation entre les deux états est pilotée par une tension de consigne appliquée sur la grille par des moyens de commande adaptés.

En particulier, la commutation entre l'état bloqué et l'état passant comprend une phase de commutation à l'amorçage consistant à commuter le transistor de l'état bloqué vers l'état passant, et une phase de commutation au blocage consistant à commuter le transistor de l'état passant vers l'état bloqué.

Généralement, le fonctionnement d'un transistor du type SiC ou GaN MOSFET est contrôlé par un dispositif de commutation adapté permettant notamment de détecter un court-circuit au sein du circuit électrique dans lequel le transistor est utilisé.

Un tel court-circuit est susceptible d'apparaitre par exemple entre le drain et la source d'un transistor SiC ou GaN MOSFET.

Pour détecter un court-circuit, les dispositifs de commutation existants utilisent un circuit de protection mesurant directement la tension entre le drain et la source et détectant en fonction de ces mesures un court-circuit. En d'autres termes, dans les dispositifs existants le circuit de protection est relié d'une part au drain et d'autre part à la source pour en mesurer directement la tension.

Toutefois, les dispositifs de commutation existants ainsi que les procédés de détection de court-circuit mis en oeuvre par ces dispositifs, ne sont pas complètement satisfaisants.

En effet, les dispositifs existants sont hérités de transistors de type IGBT (de l'anglais *«Insulated Gate Bipolar Transistor»*). De tels dispositifs ne sont pas adaptés aux transistors de type SiC ou GaN MOSFET.

Les transistors de type SiC ou GaN MOSFET sont aptes à atteindre des vitesses de commutation, et donc des fréquences de commutation, plus élevés que celles des transistors de type IGBT. Ceci permet de réduire le volume, le poids et le coût des composants utilisés dans le dispositif de commutation.

Cependant, les interférences électromagnétiques générées en fonctionnement haute fréquence des transistors de type Sic ou GaN MOSFET ne sont pas négligeables. En particulier, elles génèrent un courant de mode commun qui perturbe les composants électroniques au voisinage du transistor, y compris le circuit de protection relié à la fois au drain et à la source.

Dans le cas d'un transistor de type Sic ou GaN MOSFET commutant à haute fréquence, le courant de mode commun est suffisamment important pour déclencher de fausses alertes qui vont provoquer l'arrêt du dispositif de commutation. Il est alors nécessaire d'insérer un filtrage renforcé pour filtrer le courant en mode commun entre la source et le circuit de protection.

Par ailleurs, contrairement aux transistors de type IGBT, les transistors de type SiC ou GaN MOSFET ne désaturent pas en court-circuit. Le courant de court-circuit n'est donc pas limité par désaturation pour les transistors de type SiC ou GaN MOSFET ce qui est en revanche le cas pour les transistors IGBT.

En outre, la résistance à l'état passant d'un transistor de type SiC ou GaN MOSFET étant bien plus faible que pour un transistor de type IGBT, le courant de court-circuit est bien plus important dans le cas d'un transistor de type SiC ou GaN MOSFET que dans le cas d'un transistor de type IGBT.

Afin de prévenir la destruction d'un transistor de type SiC ou GaN MOSFET, il est donc nécessaire que le temps de réaction du circuit de protection soit très court, de l'ordre d'une ou de deux microsecondes.

Cette contrainte de réactivité impose d'alléger le filtrage en entrée du circuit de protection. Dans le même temps, comme explicité précédemment, le filtrage en entrée du circuit de protection doit être renforcé pour filtrer le courant en mode commun.

Les dispositifs existants ne permettent alors pas d'obtenir un compromis satisfaisant entre réactivité du circuit de protection et immunité du même circuit aux interférences électromagnétiques produites lorsque le transistor opère à fréquence élevée.

Ce problème est particulièrement pertinent dans le domaine ferroviaire où les transistors de type Sic ou GaN MOSFET opèrent à fréquence élevée.

La présente invention a pour but de proposer un dispositif de commutation de transistor Sic ou GaN MOSFET performant et robuste pour des vitesses de commutation élevées.

À cet effet, l'invention a pour objet un dispositif de commutation de puissance selon la revendication 1.

Ainsi, par rapport aux circuits de protection existants, la présente invention est basée sur une mesure de courant (et non de tension) qui plus est, une mesure indirecte du courant, à partir du champ électromagnétique rayonnée par le transistor, ce qui permet le découplage entre la source de perturbation (i.e. le transistor) et le circuit de protection.

En effet, selon la présente invention, par « indirecte » on entend que le circuit de protection n'est pas connecté à la source du transistor, ce qui permet de le protéger du courant en mode commun généré par le transistor en cas de court-circuit.

Suivant d'autres aspects avantageux de l'invention, le procédé comprend une ou plusieurs des caractéristiques suivantes, prise(s) isolément ou suivant toutes les combinaisons techniquement possibles :
- le module de mesure comprend une antenne isolée galvaniquement du transistor ;
- l'antenne est située dans un cercle dont le centre est le transistor et dont le rayon est compris entre 1mm et 10cm ;
- le dispositif de commutation comprend une pluralité de transistors ;
- le dispositif de commutation comprend autant de modules de mesure que de transistors, chaque transistor étant associé à un module de mesure distinct, chaque module de mesure étant configuré pour mesurer le courant principal parcourant le transistor auquel il est associé ;
- chaque module de mesure est isolé électromagnétiquement d'au moins un autre champ électromagnétique que celui produit par le transistor auquel il est associé ;
- chaque module de mesure et son transistor associé sont disposés dans une cage de Faraday ;
- chaque transistor est associé à une fenêtre d'observation du signe de la dérivée temporelle du courant principal le parcourant, la fenêtre d'observation étant propre à être déclenchée simultanément à la commutation du transistor d'un état bloqué vers un état passant, les fenêtres d'observations étant distinctes entre elles ;
- le dispositif de commutation comprend un unique module de mesure configuré pour mesurer le courant principal parcourant chaque transistor ;
- chaque transistor est associé à une fenêtre d'observation du signe de la dérivée temporelle du courant principal le parcourant, la fenêtre d'observation étant propre à être déclenchée simultanément à la commutation du transistor d'un état bloqué vers un état passant, les fenêtres d'observations étant distinctes entre elles.

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une vue schématique d'un dispositif de commutation de puissance selon un premier mode de réalisation de l'invention ;
- la figure 2 est une vue schématique d'un dispositif de commutation de puissance selon un deuxième mode de réalisation de l'invention ;
- la figure 3 est une vue schématique d'un dispositif de commutation de puissance selon un troisième mode de réalisation de l'invention ; et
- la figure 4 est un organigramme d'un procédé de détection de court-circuit mis en oeuvre par le dispositif de commutation de la figure 1.

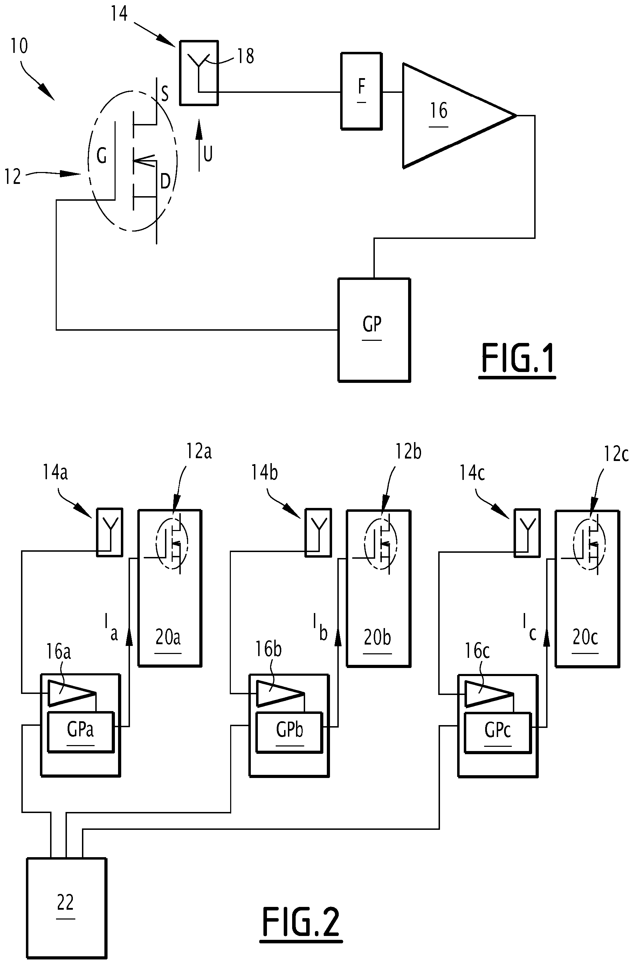

On a représenté sur les figures 1 à 3, un dispositif de commutation de puissance 10 destiné à convertir l'énergie électrique.

Le dispositif de commutation de puissance 10 est notamment utilisable dans le domaine ferroviaire et est, par exemple, embarqué dans un véhicule ferroviaire.

En référence à la figure 1, le dispositif de commutation 10 comprend au moins un transistor 12, au moins un module de mesure 14 et au moins un circuit de protection 16.

Le transistor 12 est un transistor du type SiC ou GaN MOSFET (de l'anglais, respectivement, *«Silicon Carbide*», *«Gallium Nitride»* et *« Métal Oxide Semiconductor Field Effect Transistor »*) appelé également transistor à effet de champ à grille isolée.

Le transistor 12 est connu en soi et comporte en particulier trois bornes ou contacts électriques, à savoir, une grille G, un drain D et une source S.

Le transistor 12 définit un état passant dans lequel un courant électrique I, appelé par la suite courant principal, s'écoule entre le drain D et la source S et un état bloqué dans lequel le drain D est isolé électriquement de la source S.

Le module de mesure 14 est configuré pour mesurer indirectement l'intensité du courant principal I passant dans le transistor 12 à partir du champ électromagnétique produit par le transistor 12.

En effet, le champ électromagnétique rayonné par le transistor 12 est, par définition, l'image du courant principal I selon une relation bijective, le champ électromagnétique rayonné par le transistor induisant, par définition, un courant en mode commun. Ainsi, le champ électromagnétique mesuré est plus puissant en présence qu'en l'absence de court-circuit au sein du transistor 12.

Ainsi, de manière indirecte, en utilisant le champ électromagnétique rayonné par le transistor 12, le module de mesure 14 est propre à détecter tout changement de l'intensité du courant principal I parcourant le transistor 12.

Autrement dit, le module de mesure 14 permet de détecter toute croissance ou toute décroissance des valeurs d'intensité du courant principal I dans le temps.

En d'autres termes, le module de mesure 14 permet de détecter le signe de la dérivée temporelle dl/dt du courant principal I.

De préférence, le module de mesure 14 comprend une antenne 18, isolée galvaniquement du transistor 12, et apte à mesurer le champ électromagnétique rayonné par le transistor 12. Le champ électromagnétique produit par le transistor 12 est reçu via l'antenne 18 et induit un courant en mode commun dont l'intensité, déterminée au sein du module de mesure 14, est corrélée à l'intensité du courant principal I parcourant le transistor 12.

Avantageusement, l'antenne 18 est située dans un cercle dont le centre est le transistor 12 et dont le rayon est compris entre 1mm et 10cm afin d'obtenir une mesure suffisamment précise du champ électromagnétique rayonné par le transistor 12.

Classiquement, le circuit de protection 16 est propre à être connecté d'une part à un circuit de filtrage F configuré pour filtrer les interférences électromagnétiques (IEM) du signal électromagnétique rayonné par le transistor et reçu au sein du module de mesure 14, et d'autre part à un générateur d'impulsion GP configuré pour générer une tension de consigne.

Autrement dit, selon la présente invention, le circuit de protection 16 n'est pas connecté directement, ou via le circuit de filtrage F, à la source S du transistor 12, ce qui permet de protéger le circuit de protection 16 du courant en mode commun généré en présence d'un court-circuit du transistor 12.

De plus, le circuit de protection 16 est apte à piloter le fonctionnement du transistor 12 en appliquant, via le générateur d'impulsion GP une tension de consigne et un courant de consigne sur la grille G.

Le circuit de protection 16 est connecté en outre, via le circuit de filtrage F, au module de mesure 14 pour récupérer des mesures indirectes du signe de dl/dt à partir du champ électromagnétique rayonné par le transistor 12.

Le circuit de protection 16 est apte en outre à mettre en oeuvre un procédé de détection d'un court-circuit 100, décrit plus en détail par la suite, dans une fenêtre temporelle d'observation T_{obs} prédéterminée.

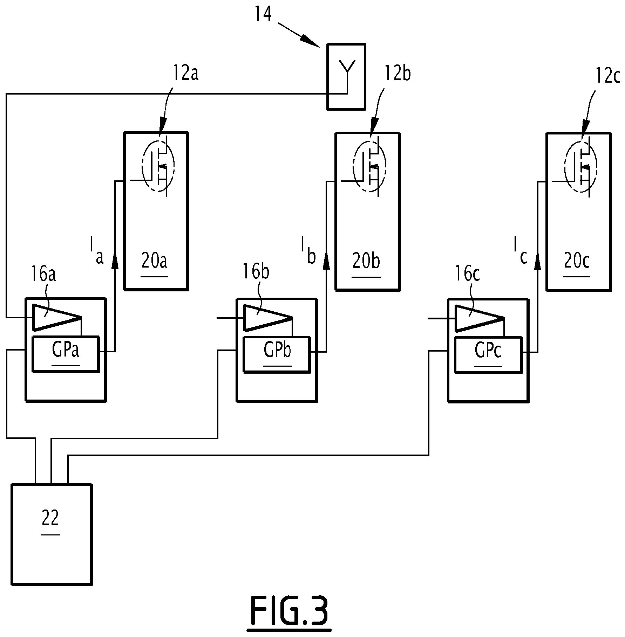

Dans les modes de réalisation représentés sur les figures 2 et 3, le dispositif 10 comporte une pluralité d'ensembles (i.e. « packs » ou « interrupteurs ») de puissances, par exemple, trois packs 20a, 20b et 20c, et une unité de contrôle 22 configurée pour piloter les commutations des transistors 12a, 12b et 12c de chaque pack. Pour ce faire, l'unité de contrôle 22 est connectée aux générateurs à impulsion GPa, GPb et GPc.

Le pack de puissance 20a comprend un transistor 12a associé à un circuit de protection 16a, à un générateur d'impulsion GPa. Le transistor 12a est parcouru par un courant principal la.

Le pack de puissance 20b comprend un transistor 12b associé à un circuit de protection 16b, à un générateur d'impulsion GPb. Le transistor 12b est parcouru par un courant principal Ib.

Le pack de puissance 20c comprend un transistor 12c associé à un circuit de protection 16c, à un générateur d'impulsion GPc. Le transistor 12c est parcouru par un courant principal Ic.

Les packs de puissance 20a, 20b et 20c bénéficient d'une configuration similaire (i.e. même vitesse de commutation, mêmes équipements, ...).

Alternativement, au moins un pack de puissance 20a, 20b et 20c est différent des autres packs.

Selon une première variante, non représentée, chaque pack 20a, 20b et 20c est respectivement associé à une fenêtre d'observation T_{obs,a}, T_{obs,b} et T_{obs,c} qui lui est dédiée par l'unité de contrôle 22.

De préférence, les fenêtres d'observation T_{obs,a}, T_{obs,b} et T_{obs,c} sont distinctes c'est-à-dire de préférence disjointes dans le temps.

La fenêtre d'observation T_{obs,a} débute simultanément à la commutation d'un état bloqué vers un état passant du transistor 12a associé. De même, la fenêtre d'observation T_{obs,b} débute simultanément à la commutation d'un état bloqué vers un état passant du transistor 12b associé et la fenêtre d'observation T_{obs,c} débute simultanément à la commutation d'un état bloqué vers un état passant du transistor 12c associé.

Ainsi, dans la fenêtre d'observation T_{obs,a}, les commutations des transistors 12b et 12c d'un état bloqué vers un état passant ne perturbent pas la mesure du champ électromagnétique rayonné par le transistor 12a.

L'unité de contrôle 22 est apte à faire commuter indépendamment les transistors 12a, 12b et 12c d'un état passant vers un état bloqué ou d'un état bloqué vers un état passant.

Selon une deuxième variante, combinée ou non avec la première variante, illustrée par la figure 2, le dispositif 10 comporte trois modules de mesure 14a, 14b et 14c respectivement associés aux packs de puissance 20a, 20b et 20c.

Plus précisément, les modules de mesures 14a, 14b et 14c sont configurés pour mesurer indirectement les courants principaux Ia, Ib et le à partir des champs électromagnétiques rayonnés respectivement par les transistors 12a, 12b et 12c.

Avantageusement, le module de mesure 14a est isolé électromagnétiquement d'au moins un autre champ électromagnétique que celui du transistor 12a auquel il est associé. En d'autres termes, le module de mesure 14a est isolé des champs électromagnétiques produits par les transistors 12b et 12c.

Pour ce faire, le module de mesure 14a et le transistor 12a associé sont, par exemple, placés dans une cage de Faraday ou dans un boitier isolé électromagnétiquement (i.e. de blindage) non représenté.

Les modules de mesures 14b et 14c et les transistors associés 12b et 12c bénéficient avantageusement d'une configuration similaire.

Autrement dit, selon cette variante, une protection individuelle de chaque pack est mise en oeuvre.

Selon une troisième variante, combinée ou non avec la première variante, illustrée par la figure 3, le dispositif 10 comporte un seul module de mesure 14.

Le module de mesure 14 est configuré pour déterminer indirectement la variation du courant produit par les packs le à partir des champs électromagnétiques rayonnés respectivement par les transistors 12a, 12b et 12c.

Avantageusement, le module de mesure 14 est situé à équidistance des transistors 12a, 12b et 12c.

Le module de mesure 14 communique ses mesures au circuit de protection associé à l'un des packs, par exemple le circuit de protection 16a, qui, tel que représenté sur la figure 3 les traite et transfère le résultat de traitement à l'unité de contrôle 22. Lorsque ce résultat de traitement identifie la présence d'un court-circuit, l'unité de contrôle 22 génère une commande d'ouverture globale de tous les packs de puissance (i.e. interrupteurs de puissance) 20a, 20b, 20c pour les protéger du court-circuit détecté.

A titre d'alternative, non représentée, le circuit de protection 16a est propre à communiquer ou à être connecté aux circuits de protections 16b et 16c associés aux autres packs de puissance 20b et 20c.

Le fonctionnement du dispositif de commutation 10 sera désormais expliqué en référence au mode de réalisation mono-transistor de la figure 1.

Lors de la phase de commutation du transistor 12 de l'état bloqué à l'état passant, le dispositif de commutation de puissance 10 met en oeuvre le procédé 100 de détection d'un court-circuit.

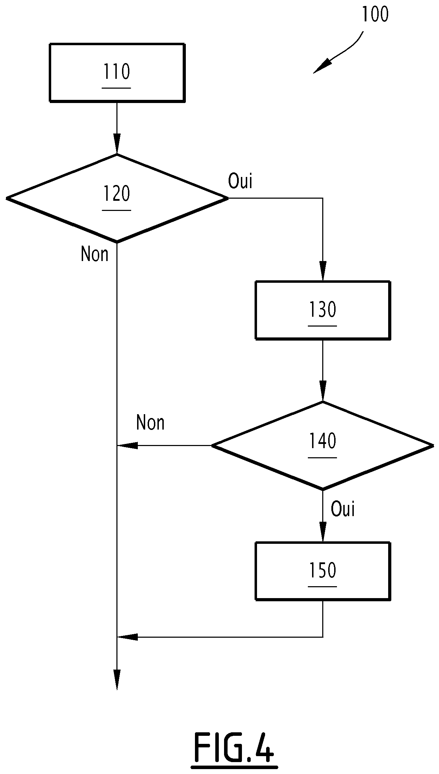

En particulier, ce procédé 100 comprend plusieurs étapes dont l'organigramme est illustré sur la figure 4.

Lors d'une première étape 110, le module de mesure 14 mesure le champ électromagnétique générée par le transistor 12. A partir de cette mesure, le module de mesure 14 détermine le signe de la dérivée temporelle dl/dt du courant principal I.

A l'étape 120, le circuit de protection 16 observe le signe de la dérivée temporelle dl/dt du courant principal I dans la fenêtre temporelle d'observation T_{obs}.

Si la dérivée temporelle dl/dt du courant principal I est strictement positive lors d'une période de test Tₜₑₛₜ comprise dans la fenêtre temporelle d'observation T_{obs} prédéterminée, le circuit de protection 16 détecte la présence d'un court-circuit lors d'une étape 130. Dans le cas contraire, le circuit de protection 16 déduit l'absence de court-circuit.

Avantageusement, le procédé 100 comprend en outre une étape 140 lors de laquelle le circuit de protection 16 confirme la présence du court-circuit détecté.

En particulier, lors de cette étape 140, le circuit de protection 16 confirme la présence du court-circuit lorsque la dérivée temporelle dl/dt du courant principal I reste supérieure ou égale à zéro pendant une période complémentaire suivant la période de test Tₜₑₛₜ. Si la dérivée temporelle dl/dt du courant principal I est strictement positive lors de la période complémentaire, le circuit de protection 16 détecte la présence d'un court-circuit lors d'une étape 150. Dans le cas contraire, le circuit de protection 16 déduit l'absence de court-circuit.

La période complémentaire débute à la fin de la période de test Tₜₑₛₜ et se termine par exemple avec la fenêtre temporelle d'observation T_{obs}.

La période de test Tₜₑₛₜ et la période complémentaire sont comprises dans la fenêtre d'observation T_{obs}.

Lorsqu'un court-circuit a été détecté, le circuit de protection 16 signale alors un court-circuit et maintient le transistor 12 dans l'état bloqué au moins pendant une période de blocage prédéterminé.

La période de test Tₜₑₛₜ est paramétrable par le circuit de protection 16 et réglée préalablement à la mise en oeuvre du procédé 100, par exemple, entre dix nanosecondes et quinze microsecondes.

La longueur de la fenêtre d'observation T_{obs} est paramétrable par le circuit de protection 16 et réglée préalablement à la mise en oeuvre du procédé 100, par exemple, entre dix nanosecondes et quinze microsecondes.

On conçoit alors que la présente invention présente un certain nombre d'avantages.

Le procédé de détection selon l'invention permet de détecter un court-circuit dans le transistor en utilisant uniquement l'analyse du signe de la dérivée dl/dt du courant principal I dans différentes périodes temporelles.

Le dispositif selon l'invention ne modifie pas le circuit de puissance. Les pertes d'énergies par commutation et les risques de surtension ne sont donc pas augmentés.

Il est à noter que les mesures indirectes de courant à partir du champ électromagnétique rayonné sont plus précises que les mesures de tension pour les transistors de type SiC ou GAN MOSFET étant donné que la tension de désaturation est fortement dépendante de la température.

En outre, seul le signe de la dérivée dl/dt est important pour mettre en oeuvre le procédé 100. Aucune mesure de la valeur du courant principal I ni de celle de sa dérivée dl/dt ne sont nécessaires ce qui permet de simplifier les exigences imposées aux différents moyens de mesure.

Ceci est particulièrement avantageux pour les transistors fonctionnant sous haute tension notamment comme ceux utilisés dans le domaine ferroviaire.

Par ailleurs, la mesure du signe de la dérivée dl/dt est effectuée par une mesure indirecte à partir du champ électromagnétique rayonné par le transistor 12.

Ainsi, le circuit de protection 16 n'est pas affecté par le courant en mode commun, car il n'est pas directement, ou via le circuit de filtrage F, relié à la source S du transistor SiC ou GAN MOSFET. Il en résulte également que le dispositif 10 est beaucoup moins sensible à la compatibilité électromagnétique CEM du circuit de protection 16 par rapport aux dispositifs existants. Il est donc inutile de renforcer le filtrage F de sorte que le temps de réaction du circuit de protection 16 est réduit par rapport aux dispositifs existants.

## Revendications

1. Dispositif de commutation de puissance (10) comprenant au moins un transistor (12 ; 12a, 12b, 12c) de type SiC ou GaN MOSFET propre à être parcouru par un courant principal (I; Ia, Ib, Ic) ;
le dispositif de commutation (10) comprenant au moins un module de mesure (14 ; 14a, 14b, 14c) configuré pour mesurer indirectement le courant principal (I) du transistor (12 ; 12a, 12b, 12c) à partir du champ électromagnétique produit par le transistor (12 ; 12a, 12b, 12c),
**caractérisé en ce que** le dispositif de commutation comprend au moins un circuit de protection (16 ; 16a, 16b, 16c) configuré pour détecter un court-circuit en fonction du signe de la dérivée temporelle du courant principal (I ; Ia, Ib, Ic)
le circuit de protection (16) étant connecté, via un circuit de filtrage (F), au module de mesure (14) pour récupérer des mesures indirectes du signe de la dérivée temporelle du courant principal à partir du champ électromagnétique rayonné par le transistor (12).

2. Dispositif de commutation (10) selon l'une quelconque des revendications précédentes, dans lequel le module de mesure (14; 14a, 14b, 14c) comprend une antenne (18) isolée galvaniquement du transistor (12 ; 12a, 12b, 12c).

3. Dispositif de commutation (10) selon la revendication 2, dans lequel l'antenne (18) est située dans un cercle dont le centre est le transistor (12 ; 12a, 12b, 12c) et dont le rayon est compris entre 1mm et 10cm.

4. Dispositif de commutation (10) selon l'une quelconque des revendications précédentes, dans lequel le dispositif de commutation (10) comprend une pluralité de transistors (12a, 12b, 12c).

5. Dispositif de commutation (10) selon la revendication 4, dans lequel le dispositif de commutation (10) comprend autant de modules de mesure (14a, 14b, 14c) que de transistors (12a, 12b, 12c), chaque transistor (12a, 12b, 12c) étant associé à un module de mesure (14a, 14b, 14c) distinct, chaque module de mesure (14a, 14b, 14c) étant configuré pour mesurer le courant principal (Ia, Ib, Ic) parcourant le transistor (12a, 12b, 12c) auquel il est associé.

6. Dispositif de commutation (10) selon la revendication 5, dans lequel chaque module de mesure (14a, 14b, 14c) est isolé électromagnétiquement d'au moins un autre champ électromagnétique que celui produit par le transistor (12a, 12b, 12c) auquel il est associé.

7. Dispositif de commutation (10) selon la revendication 6, dans lequel chaque module de mesure (14a, 14b, 14c) et son transistor (12a, 12b, 12c) associé sont disposés dans une cage de Faraday.

8. Dispositif de commutation (10) selon l'une quelconque des revendications 4 à 7, dans lequel chaque transistor (12a, 12b, 12c) est associé à une fenêtre (T_{obs,a}, T_{obs,b}, T_{obs,c}) d'observation du signe de la dérivée temporelle du courant principal (Ia, Ib, Ic) le parcourant, la fenêtre d'observation (T_{obs,a}, T_{obs,b}, T_{obs,c}) étant propre à être déclenchée simultanément à la commutation du transistor (12a, 12b, 12c) d'un état bloqué vers un état passant, les fenêtres d'observations (T_{obs,a}, T_{obs,b}, T_{obs,c}) étant distinctes entre elles.

9. Dispositif de commutation (10) selon la revendication 4, dans lequel le dispositif de commutation (10) comprend un unique module de mesure (14) configuré pour mesurer le courant principal (Ia, Ib, Ic) parcourant chaque transistor (12a, 12b, 12c).

10. Dispositif de commutation (10) selon la revendication 9, dans lequel chaque transistor (12a, 12b, 12c) est associé à une fenêtre (T_{obs,a}, T_{obs,b}, T_{obs,c}) d'observation du signe de la dérivée temporelle du courant principal (Ia, Ib, Ic) le parcourant, la fenêtre d'observation (T_{obs,a}, T_{obs,b}, T_{obs,c}) étant propre à être déclenchée simultanément à la commutation du transistor (12a, 12b, 12c) d'un état bloqué vers un état passant, les fenêtres d'observations (T_{obs,a}, T_{obs,b}, T_{obs,c}) étant distinctes entre elles.

## Patentansprüche

1. Leistungsschaltvorrichtung (10) mit mindestens einem Transistor (12; 12a, 12b, 12c) vom Typ SiC oder GaN MOSFET, der geeignet ist, von einem Hauptstrom (I; Ia, Ib, Ic) durchflossen zu werden;
die Schaltvorrichtung (10) mindestens ein Messmodul (14; 14a, 14b, 14c) umfasst, das konfiguriert ist, um den Hauptstrom (I) des Transistors (12; 12a, 12b, 12c) indirekt aus dem von dem Transistor (12; 12a, 12b, 12c) erzeugten elektromagnetischen Feld zu messen, **dadurch gekennzeichnet, dass** die Schaltvorrichtung mindestens eine Schutzschaltung (16; 16a, 16b, 16c) umfasst, die so konfiguriert ist, dass sie einen Kurzschluss in Abhängigkeit vom Vorzeichen der zeitlichen Ableitung des Hauptstroms (I; Ia, Ib, Ic) erfasst
wobei die Schutzschaltung (16) über eine Filterschaltung (F) mit dem Messmodul (14) verbunden ist, um indirekte Messungen des Vorzeichens der zeitlichen Ableitung des Hauptstroms aus dem von dem Transistor (12) abgestrahlten elektromagnetischen Feld wiederzugewinnen.

2. Schaltvorrichtung (10) nach einem der vorhergehenden Ansprüche, wobei das Messmodul (14; 14a, 14b, 14c) eine Antenne (18) umfasst, die galvanisch von dem Transistor (12; 12a, 12b, 12c) isoliert ist.

3. Schaltvorrichtung (10) nach Anspruch 2, bei der sich die Antenne (18) in einem Kreis befindet, dessen Mittelpunkt der Transistor (12; 12a, 12b, 12c) ist und dessen Radius zwischen 1 mm und 10 cm liegt.

4. Schaltvorrichtung (10) nach einem der vorhergehenden Ansprüche, wobei die Schaltvorrichtung (10) eine Vielzahl von Transistoren (12a, 12b, 12c) umfasst.

5. Schaltvorrichtung (10) nach Anspruch 4, wobei die Schaltvorrichtung (10) so viele Messmodule (14a, 14b, 14c) wie Transistoren (12a, 12b, 12c) umfasst, wobei jeder Transistor (12a, 12b, 12c) einem separaten Messmodul (14a, 14b, 14c) zugeordnet ist, wobei jedes Messmodul (14a, 14b, 14c) so konfiguriert ist, dass es den Hauptstrom (Ia, Ib, Ic) misst, der durch den Transistor (12a, 12b, 12c) fließt, mit dem es verbunden ist.

6. Schaltvorrichtung (10) nach Anspruch 5, wobei jedes Messmodul (14a, 14b, 14c) elektromagnetisch von mindestens einem anderen elektromagnetischen Feld isoliert ist als dem, das von dem Transistor (12a, 12b, 12c), dem es zugeordnet ist, erzeugt wird.

7. Schaltvorrichtung (10) nach Anspruch 6, bei der jedes Messmodul (14a, 14b, 14c) und sein zugehöriger Transistor (12a, 12b, 12c) in einem Faradayschen Käfig angeordnet sind.

8. Schaltvorrichtung (10) nach einem der Ansprüche 4 bis 7, bei der jeder Transistor (12a, 12b, 12c) mit einem Fenster (T_{obs,a}, T_{obs,b}, T_{obs,c}) zur Beobachtung des Vorzeichens der zeitlichen Ableitung des Hauptstroms (Ia, Ib, Ic), der durch ihn fließt verbunden ist, wobei das Beobachtungsfenster (T_{obs,a}, T_{obs,b}, T_{obs,c}) dazu geeignet ist, gleichzeitig mit dem Umschalten des Transistors (12a, 12b, 12c) aus einem gesperrten Zustand in einen eingeschalteten Zustand zu schalten, wobei die Beobachtungsfenster (T_{obs,a}, T_{obs,b}, T_{obs,c}) voneinander verschieden sind.

9. Schaltvorrichtung (10) nach Anspruch 4, wobei die Schaltvorrichtung (10) ein einzelnes Messmodul (14) umfasst, das so konfiguriert ist, dass es den Hauptstrom (Ia, Ib, Ic) misst, der durch jeden Transistor (12a, 12b, 12c) fließt.

10. Schaltvorrichtung (10) nach Anspruch 9, in der jeder Transistor (12a, 12b, 12c) mit einem Fenster (T_{obs,a}, T_{obs,b}, T_{obs,c}) zur Beobachtung des Vorzeichens der zeitlichen Ableitung des Hauptstroms (Ia, Ib, Ic), der durch ihn fließt, verbunden ist, wobei das Beobachtungsfenster (T_{obs,a}, T_{obs,b}, T_{obs,c}) dazu geeignet ist, gleichzeitig mit dem Umschalten des Transistors (12a, 12b, 12c) aus einem gesperrten Zustand in einen eingeschalteten Zustand zu schalten, wobei die Beobachtungsfenster (T_{obs,a}, T_{obs,b}, T_{obs,c}) voneinander verschieden sind.

## Claims

1. A power switching device (10) comprising at least one transistor (12 ; 12a, 12b, 12c) of the SiC or GaN MOSFET type able to be traveled by a main current (I ; Ia, Ib, Ic);
the switching device (10) comprising at least one measuring module (14 ; 14a, 14b, 14c) configured to indirectly measure the main current (I) of the transistor (12 ; 12a, 12b, 12c) from the electromagnetic field produced by the transistor (12 ; 12a, 12b, 12c),
**characterised in that** the switching device comprises at least one protection circuit (16 ; 16a, 16b, 16c) configured to detect a short-circuit based on the sign of the temporal derivative of the main current (I ; Ia, Ib, Ic)
the protection circuit (16) being connected, via a filter circuit (F), to the measuring module (14) to obtain indirect measurements of the sign of the temporal derivative of the main current from the electromagnetic field radiated by the transistor (12).

2. The switching device (10) according to claim 1, wherein the measuring module (14 ; 14a, 14b, 14c) comprises an antenna galvanically isolated from the transistor (12 ; 12a, 12b, 12c).

3. The switching device (10) according to claim 2, wherein the antenna (18) is located in a circle, the center of which is the transistor (12 ; 12a, 12b, 12c) and the radius of which is comprised between 1 mm and 10 cm.

4. The switching device (10) according to any one of the preceding claims, wherein the switching device (10) comprises multiple transistors (12a, 12b, 12c).

5. The switching device (10) according to claim 4, wherein the switching device (10) comprises as many measuring modules (14a, 14b, 14c) as transistors (12a, 12b, 12c), each transistor (12a, 12b, 12c) being associated with a separate measuring module (14a, 14b, 14c), each measuring module (14a, 14b, 14c) being configured (Ia, Ib, Ic) to measure the main current traveling the transistor (12a, 12b, 12c) with which it is associated.

6. The switching device (10) according to claim 5, wherein each measuring module (14a, 14b, 14c) is electromagnetically isolated from at least one electromagnetic field other than that produced by the transistor (12a, 12b, 12c) with which it is associated.

7. The switching device (10) according to claim 6, wherein each measuring module (14a, 14b, 14c) and its associated transistor (12a, 12b, 12c) are arranged in a Faraday cage.

8. The switching device (10) according to any one of the preceding claims 4 to 7, wherein each transistor (12a, 12b, 12c) is associated with an observation window (T_{obs,a}, T_{obs,b}, T_{obs,c}) for the sign of the temporal derivative of the main current (Ia, Ib, Ic) traveling it, the observation window (T_{obs,a}, T_{obs,b}, T_{obs,c}) being able to be triggered simultaneously with the switching of the transistor (12a, 12b, 12c) from an off state to an on state, the observation windows (T_{obs,a}, T_{obs,b}, T_{obs,c}) being separate from one another.

9. The switching device (10) according to claim 4, wherein the switching device (10) comprises a single measuring module (14) configured to measure the main current (Ia, Ib, Ic) traveling each transistor (12a, 12b, 12c).

10. The switching device (10) according to claim 9, wherein each transistor (12a, 12b, 12c) is associated with an observation window (T_{obs,a}, T_{obs,b}, T_{obs,c}) for the sign of the temporal derivative of the main current (Ia, Ib, Ic) traveling it, the observation window (T_{obs,a}, T_{obs,b}, T_{obs,c}) being able to be triggered simultaneously with the switching of the transistor (12a, 12b, 12c) from an off state to an on state, the observation windows (T_{obs,a}, T_{obs,b}, T_{obs,c}) being separate from one another.
